# EUROPEAN PATENT APPLICATION

(11) **EP 2 445 328 A2**
(43) Date of publication of application: **25.04.2012**
(21) Application number: 12150347.8
(22) Date of filing: 23.03.2010
(51) Int. Cl.: H05K 13/00, B41M 1/12, H05K 3/00

(54) **Method and apparatus for placing substrate support components**

(30) Priority: 20.04.2009 US 426558
(62) Divisional of application: 10716926.0
(71) Applicant: Illinois Tool Works Inc., Glenview, IL 60026 (US)
(72) Inventor: Doyle, Dennis, Glenview, IL Illinois 60026 (US); Donelan, Michael, Glenview, IL Illinois 60026 (US); Foster, Steven, Glenview, IL Illinois 60026 (US); Perault, Joseph, Glenview, IL Illinois 60026 (US)
(74) Representative: Finnie, Peter John

(57) **Abstract**

An apparatus for depositing viscous material on an electronic substrate includes a frame, a dispensing unit coupled to the frame, and a substrate support assembly coupled to the frame. The substrate support assembly includes a plurality of support elements, a table coupled to the frame. The table has a support surface to support at least one support element of the plurality of support elements, and a marking device coupled to the frame. The apparatus further includes an imaging system coupled to the frame. The imaging system is configured to capture images of the support surface of the table. A controller is coupled to at least the marking device and the imaging system, and configured to manipulate the marking device to mark the support surface of the table on predetermined positions and to manipulate the imaging system to verify whether the marks on the support surface of the table are accurate. Embodiments of the apparatus and related methods are further disclosed.

## Description

### RELATED APPLICATION

This application is a continuation-in-part of U.S. Patent Application Serial No. 12/031,008, filed February 14, 2008, entitled METHOD AND APPARATUS FOR PLACING SUBSTRATE SUPPORT COMPONENTS, which is currently pending and incorporated herein by reference for all purposes.

### BACKGROUND OF DISCLOSURE

### 1. Field of Disclosure

The disclosure relates generally to methods and apparatus for depositing viscous material, such as solder paste, onto a substrate, such as a printed circuit board, and more particularly to a method and apparatus for placing substrate support components, such as support pins or flexible tooling.

### 2. Discussion of Related Art

When electronic substrates, such as printed circuit boards or printed wiring boards, are subjected to manufacturing processes, such as stencil printing or dispensing, it is often desirable to uniformly support the substrate across the entire lower surface so that the entire upper surface is in the same plane. It is known to support the substrate over a table using pins that have upper support surfaces in the same plane. When the lower surface of the substrate is free of components, the pins can be mounted on a grid. When the substrate has components mounted on the bottom surface, the pins need to be located to support portions of the lower surface between the components mounted thereon. One way to locate the pins is to manually place pins having support bases with magnets on a flat upper surface of a metal support table. Another way is described in U.S. Patent No. 5,157,438 to Beale, which discloses supporting such substrates by selectively raising pins mounted in holes on a grid pattern in a housing. Yet another way is described in U.S. Patent No. 5,794,329 to Rossmeisl et al., which discloses an automated pin placement system.

### SUMMARY OF DISCLOSURE

Embodiments of the disclosure provide improvements to stencil support assemblies, such as those described above.

One aspect of the disclosure is directed to an apparatus for depositing viscous material on an electronic substrate. In one embodiment, the apparatus may comprise a frame, a unit coupled to the frame, the unit being configured to deposit material on the electronic substrate, and a substrate support assembly coupled to the frame. The substrate support assembly may be configured to support the electronic substrate. The substrate support assembly may comprise a plurality of support elements, a table coupled to the frame, the table having a support surface to support at least one support element of the plurality of support elements, a placement head configured to releasably secure the at least one support element, and a transport device coupled to the frame and the placement head. The transport device may be configured to move the placement head relative to the table in both X and Y directions to place the at least one support element on the support surface of the table in a predetermined position. The apparatus may further comprise an imaging system coupled to the frame and a controller coupled to the imaging system. The imaging system may be configured to capture images of the support surface of the table. The controller may be configured to verify whether the at least one support element is placed on the predetermined position on the support surface of the table based on images captured by the imaging system.

Embodiments of the apparatus may further comprise a display coupled to the controller. The display may be configured to display a notice to move the at least one support element when the at least one support element is not positioned on the predetermined position. The at least one support element may be moved by an operator of the apparatus to the predetermined position. The at least one support element may be moved by the placement head and the transport device to the predetermined position. The substrate support assembly may further comprise a supply tray for holding the plurality of support elements. The at least one support element may comprise a pin or a support housing having a low durometer gel configured to support the electronic substrate.

Another aspect of the disclosure is directed a method of verifying an accurate placement of a support element on a support surface of a table of an apparatus configured to deposit material on an electronic substrate. The method comprises placing at least one support element of a plurality of support elements on the support surface of the table in a predetermined position, capturing an image of the at least one support element disposed on the support surface of the table, and verifying whether the at least one support element is placed on the predetermined position on the support surface of the table based on the image captured by the imaging system.

Embodiments of the method may further comprise displaying a notice on a display of the apparatus to move the at least one support element when the at least one support element is not positioned on the predetermined position. The method may further comprise moving the at least one support element on the predetermined position in response to receiving the notice. The support element may be performed by an operator of the apparatus. Moving the support element may be performed by a placement tool of the apparatus. Placing at least one support element may comprise manually placing the at least one support element on a side of the table, and moving the at least one support element with a placement tool of the apparatus to the predetermined position. Manually placing at least one support element may comprise placing a predetermined number of support elements. The method may further comprise counting the support elements to verify whether the number of support elements equals the predetermined number.

Yet another aspect of the disclosure is directed to a computer readable medium having stored thereon sequences of instruction including instructions that will cause a processor to: place at least one support element of a plurality of support elements in a predetermined position on a support surface of a table of an apparatus to perform an operation on an electronic substrate; capture an image of the at least one support element disposed on the support surface of the table; and verify whether the at least one support element is placed on the predetermined position on the support surface of the table based on images captured by the imaging system.

Embodiments of the computer readable medium may embody having the instructions causing the processor to further display a notice on a display to an operator of the apparatus to move the at least one support element when the at least one support element is not positioned on the predetermined position. The instructions may cause the processor to further move the at least one support element on the predetermined position in response to receiving the notice. Moving the support element may be performed by the operator or by a placement tool of the apparatus.

A further aspect of the disclosure is directed to an apparatus for depositing viscous material on an electronic substrate. In a certain embodiment, the apparatus may comprise a frame, a unit coupled to the frame, the unit being configured to deposit material on the electronic substrate, and a substrate support assembly coupled to the frame. The substrate support assembly may be configured to support an electronic substrate in a print position. The substrate support assembly may comprise a plurality of support elements, a table coupled to the frame and having a support surface to support at least one support element of the plurality of support elements, a placement head configured to releasably secure the at least one support element, a transport device coupled to the frame and the placement head to move the placement head relative to the table in both X and Y directions to place the at least one support element on the support surface of the table, and a template configured to be placed on the table. The template may have at least one marking corresponding to a predetermined position for placing the at least one support element.

Embodiments of the apparatus may further comprise an imaging system coupled to the frame. The imaging system may be configured to capture images of the support surface of the table. The apparatus may further comprise a controller coupled to the imaging system. The controller may be configured to verify whether the at least one support element is placed on the predetermined position on the support surface of the table based on images captured by the imaging system. The apparatus may further comprise a display coupled to the controller. The display may be configured to display a notice to move the at least one support element when the at least one support element is not positioned on the predetermined position. The at least one support element may be moved by the operator to the predetermined position or by the placement head and the transport device to the predetermined position. The substrate support assembly may further comprise a supply tray for holding the plurality of support elements. An aspect of the disclosure is directed to an apparatus for depositing viscous material on an electronic substrate. In one embodiment, the apparatus comprises a frame, a unit coupled to the frame, the unit being configured to deposit material on the electronic substrate, and a substrate support assembly coupled to the frame, the substrate support assembly being configured to support the electronic substrate. The substrate support assembly comprises a plurality of support elements, a table coupled to the frame, the table having a support surface to support at least one support element of the plurality of support elements, and a marking device coupled to the frame, the marking device being configured to mark the support surface of the table. The apparatus further comprises an imaging system coupled to the frame, the imaging system being configured to capture images of the support surface of the table. A controller is coupled to at least the marking device and the imaging system. The controller is configured to manipulate the marking device to mark the support surface of the table on predetermined positions and to manipulate the imaging system to verify whether the plurality of support elements are accurately placed. Embodiments of the apparatus may further comprise a template configured to be placed on the support surface of the table.

Another aspect of the disclosure is directed to a method comprising: identifying at least one predetermined position on a support surface of a table for marking; making a mark on the support surface on or near the at least one predetermined position; placing a support element on or near the mark; capturing an image of the support element with an imaging system; and verifying whether the support element is placed on the at least one predetermined position based on the image captured by the imaging system. Embodiments of the method may include a template configured to be placed on the support surface. The making a mark on the support surface may further comprise using an automated marking device.

Another aspect is directed to a computer readable medium having stored thereon sequences of instruction including instructions that will cause a processor to: identify at least one predetermined position on a support surface of a table for marking; making a mark on the support surface on or near the at least one predetermined position; placing a support element on or near the mark; capture an image of the support element with an imaging system; and verify whether the support element is placed on the at least one predetermined position based on the image captured by the imaging system.

Another aspect is directed to a method of marking a support surface of a table of an apparatus configured to deposit material on an electronic substrate and verifying the accuracy of the marks. The method comprises: identifying at least one predetermined position on the support surface of the table for marking; making a mark on the support surface on or near the at least one predetermined position; manually placing a support element on or near the mark; and verifying whether the support element is placed on the at least one predetermined position. In one embodiment, making the mark on the support surface comprises placing a template on the support surface of the table. Manually placing a support element on or near the mark comprises placing a support element on or near the mark disposed on the template.

Another aspect is directed to a computer readable medium having stored thereon sequences of instruction including instructions that will cause a processor to: identify at least one predetermined position on a support surface of a table for marking; make a mark on the support surface on or near the at least one predetermined position; manually place a support element on or near the mark; and verify whether the support element is placed on the at least one predetermined position.

Another aspect is directed to a method of placing and verifying an accurate placement of a support element on a support surface of a table of an apparatus configured to deposit material on an electronic substrate. The method comprises: depositing a plurality of support elements on the support surface of the table; placing at least one support element of the plurality of support elements on the support surface of the table in a predetermined position with a placement device; capturing an image of the at least one support element disposed on the support surface of the table; and verifying whether the at least one support element is placed on the predetermined position on the support surface of the table based on the captured image. Embodiments of the method further comprise returning unused support elements to a storage location.

Another aspect is directed to a computer readable medium having stored thereon sequences of instruction including instructions that will cause a processor to: deposit a plurality of support elements on the support surface of the table; place at least one support element of the plurality of support elements on the support surface of the table in a predetermined position with a placement device; capture an image of the at least one support element disposed on the support surface of the table; and verify whether the at least one support element is placed on the predetermined position on the support surface of the table based on the captured image.

Another aspect is directed to a method of placing a plurality of support elements on a support surface of a table of an apparatus configured to deposit material on an electronic substrate, the method comprising: providing a container having a plurality of support elements; depositing the plurality of support elements on the support surface of the table; and placing at least one support element of the plurality of support elements on the support surface of the table in a predetermined position with a placement device. Embodiments of the method may further comprise capturing an image of the at least one support element disposed on the support surface of the table in the predetermined position, and verifying whether the at least one support element is placed on the predetermined position on the support surface of the table based on the captured image. The method may further comprise removing the container and returning unused support elements of the plurality of support elements to the container.

Another aspect is directed to a computer readable medium having stored thereon sequences of instruction including instructions that will cause a processor to: capture an image of the at least one support element disposed on the support surface of the table in the predetermined position, and verify whether the at least one support element is placed on the predetermined position on the support surface of the table based on the captured image. Another aspect is directed to a method of placing support elements on a support surface of a table of an apparatus configured to deposit material on an electronic substrate, the method comprising: downloading data from an external source, the data providing information related to the positioning of support elements on the support surface of the table; and placing the support elements on the support surface of the table in predetermined positions with a placement device based on the downloaded data. Embodiments of the method may further comprise capturing at least one image of the support elements disposed on the support surface of the table, and verifying whether at least some of the support elements are placed on the predetermined positions on the support surface of the table based on the at least one image captured. The data may be one of CAD data and Gerber data. The data may be taken from a third party source.

Another aspect is directed to a computer readable medium having stored thereon sequences of instruction including instructions that will cause a processor to: capture at least one image of the support elements disposed on the support surface of the table, and verify whether at least some of the support elements are placed on the predetermined positions on the support surface of the table based on the at least one image captured.

Another aspect is directed to a method for supporting a substrate within an apparatus configured to deposit material on the substrate, the method comprising: determining whether the substrate is properly supported; if not properly supported, identifying an area of the substrate requiring additional or less support; identifying at least one location on a support table to move a support element or remove a support element; and placing a support element on the at least one location if additional support is required. Embodiments of the method further comprise verifying the placement accuracy of the support element. Identifying the area of the substrate and verifying the placement accuracy may be performed with an imaging system.

Another aspect is directed to a computer readable medium having stored thereon sequences of instruction including instructions that will cause a processor to: analyze a substrate to determine whether the substrate is properly supported; if not properly supported, identify an area of the substrate requiring additional or less support; mark at least one location on a support table to move a support element if additional support is required; and place a support element on the at least one location or remove a support element.

Another aspect is directed to a method of placing support elements on a support surface of a table of an apparatus configured to deposit material on an electronic substrate, the method comprising: identifying the positions of support elements on the support surface of the table; optimizing the placement positions of the support elements on the support surface of the table with a placement device; and placing the support elements on the positions of the support surface of the table with the placement device. In one embodiment, the identifying the positions of the support elements comprises downloading data from an external source, the data providing information related to the positions of the support elements on the support surface of the table. The optimizing the placement of the support elements comprises placing support elements with the placement device from an outward position to an inward position.

Another aspect is directed to a computer readable medium having stored thereon sequences of instruction including instructions that will cause a processor to: identify the positions of support elements on the support surface of the table; optimize the placement of the support elements on the support surface of the table with a placement device; and place the support elements on the positions of the support surface of the table with the placement device.

Another aspect is directed to a method for printing material on a substrate, the method comprising: printing material on the substrate with a stencil printer; inspecting the substrate to determine whether material is properly printed on the substrate; if not properly printed, analyzing the substrate to determine whether the substrate is properly supported; if not properly supported, identifying an area of the substrate requiring additional or less support; moving a support element on the at least one location or removing a support element; and printing material on a subsequent substrate with the stencil printer. Embodiments of the method further comprise verifying the placement accuracy of the support element, and/or marking at least one location on a support table to position a support element. Identifying the area of the substrate and verifying the placement accuracy are performed with an imaging system.

Another aspect is directed to a computer readable medium having stored thereon sequences of instruction including instructions that will cause a processor to: print material on the substrate with a stencil printer; inspect the substrate to determine whether material is properly printed on the substrate; if not properly printed, analyze the substrate to determine whether the substrate is properly supported; if not properly supported, identify an area of the substrate requiring additional support if additional support is required; move a support element on the at least one location or remove a support element; and print material on a subsequent substrate with the stencil printer.

Another aspect is directed to a method for printing material on a substrate, the method comprising: printing material on the substrate with a print head of a stencil printer; monitoring print pressure of the print head; if a change in print pressure is detected, analyzing the substrate to determine whether the substrate is properly supported; if not properly supported, identifying an area of the substrate requiring additional or less support; placing a support element on the at least one location if additional support is required or removing a support element; and printing material on a subsequent substrate with the stencil printer.

Embodiments of the method further comprise verifying the placement accuracy of the support element, and/or marking at least one location on a support table to position a support element. Identifying the area of the substrate and verifying the placement accuracy are performed with an imaging system. Another aspect is directed to a computer readable medium having stored thereon sequences of instruction including instructions that will cause a processor to: print material on the substrate with a print head of a stencil printer; monitor print pressure of the print head; if a change in print pressure is detected, analyze the substrate to determine whether the substrate is properly supported; if not properly supported, identify an area of the substrate requiring additional or less support; place a support element on the at least one location if additional support in required or remove a support element; and print material on a subsequent substrate with the stencil printer.

Another aspect is directed to a method of printing material on a top surface of a substrate of the type having a top surface and a bottom surface, the method comprising: delivering a substrate to a stencil printer with the bottom surface of the substrate facing upwardly; capturing at least one image of the bottom surface of the substrate; recommending placement positions of support elements on a table of the stencil printer based on the at least one image; delivering the substrate to the stencil printer with the top surface of the substrate facing upwardly; supporting the substrate with the support elements; and performing a print operation to print material on the top surface of the substrate.

Another aspect is directed to a computer readable medium having stored thereon sequences of instruction including instructions that will cause a processor to: deliver a substrate to a stencil printer with the bottom surface of the substrate facing upwardly; capture at least one image of the bottom surface of the substrate; recommend placement positions of support elements on a table of the stencil printer based on the at least one image; deliver the substrate to the stencil printer with the top surface of the substrate facing upwardly; support the substrate with the support elements; and perform a print operation to print material on the top surface of the substrate.

Another aspect is directed to a method of printing material on a top surface of a substrate of the type having a top surface and a bottom surface including electronic components placed on the bottom surface, the method comprising: delivering a substrate to a stencil printer with the bottom surface of the substrate facing upwardly; determining the location of components placed on the bottom surface of the substrate; determining locations of support elements on a table of the stencil printer based on the determination of the location of components; placing the support elements on the locations; delivering the substrate to the stencil printer with the top surface of the substrate facing upwardly; supporting the substrate with the support elements between the components; and performing a print operation to print material on the top surface of the substrate. In one embodiment, determining the location of components comprises capturing at least one image of the bottom surface of the substrate to determine the position of the components, and using a device to determine heights of components. Placing the support elements on the locations comprises adjusting the heights of the support elements. Another aspect is directed to a computer readable medium having stored thereon sequences of instruction including instructions that will cause a processor to: deliver a substrate to a stencil printer with the bottom surface of the substrate facing upwardly; determine the location of components placed on the bottom surface of the substrate; determine locations of support elements on a table of the stencil printer based on the at least one image; placing the support elements on the locations; deliver the substrate to the stencil printer with the top surface of the substrate facing upwardly; support the substrate with the support elements; and perform a print operation to print material on the top surface of the substrate.

Another aspect is directed to a method of placing support elements on a support surface of a table of an apparatus configured to deposit material on an electronic substrate, the method comprising: placing at least one support element on the support surface of the table in a predetermined position with a placement device; and adjusting a height of the at least one support element with the placement device. Embodiments of the method further comprise capturing an image of the at least one support element disposed on the support surface of the table, and verifying whether the at least one support element is placed on the predetermined position on the support surface of the table based on the captured image. The method may further comprise verifying the height of the at least one support element. Another aspect is directed to a computer readable medium having stored thereon sequences of instruction including instructions that will cause a processor to: place at least one support element on the support surface of the table in a predetermined position with a placement device; and adjust a height of the at least one support element with the placement device. Another aspect is directed to a method comprising: identifying at least one predetermined position on a support surface of a table for marking; placing a support element on the at least one predetermined position; inspecting the accuracy of placement of the support element on the at least one predetermined position.

### BRIEF DESCRIPTION OF DRAWINGS

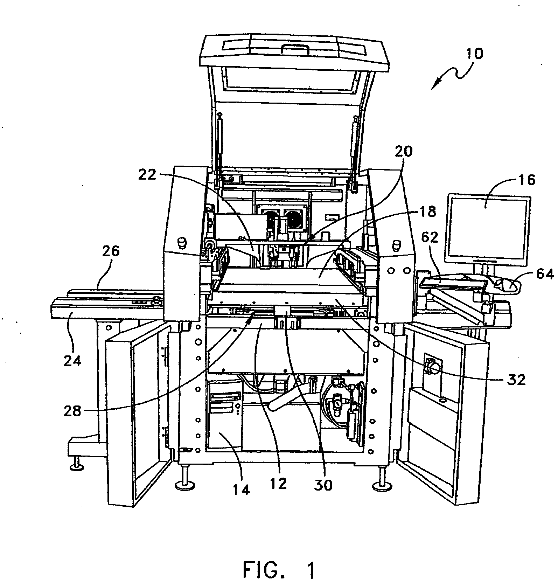

The accompanying drawings are not intended to be drawn to scale. In the drawings, each identical or nearly identical component that is illustrated in various figures is represented by a like numeral. For purposes of clarity, not every component may be labeled in every drawing. In the drawings: FIG. 1 is a front perspective view of an apparatus of an embodiment of the disclosure for depositing material on an electronic substrate;
FIG. 2 is a top plan schematic view of a substrate support assembly of an embodiment of the disclosure;
FIG. 3 is a perspective view of a tray having support elements of the substrate support system shown in FIG. 2;
FIG. 4 is a side perspective view of a placement head and the tray of the substrate support system shown in FIG. 2;
FIG. 4A is a side perspective view of a placement head configured with a marking device;
FIG. 5 is a view showing a screen display of an embodiment of the disclosure;
FIG. 6 is a view showing a template of an embodiment of the disclosure;
FIG. 7 is a view showing a template of another embodiment of the disclosure; and
FIGS. 8-20 are functional block diagrams showing methods of embodiments of the disclosure.

### DETAILED DESCRIPTION

This disclosure is not limited in its application to the details of construction and the arrangement of components set forth in the following description or illustrated in the drawings. The disclosure is capable of other embodiments and of being practiced or of being carried out in various ways. Also, the phraseology and terminology used herein is for the purpose of description and should not be regarded as limiting. The use of "including," "comprising," "having," "containing," "involving," and variations thereof herein, is meant to encompass the items listed thereafter and equivalents thereof as well as additional items. For purposes of illustration, embodiments of the disclosure will now be described with reference to a stencil printer used to print solder paste onto a printed circuit board. One skilled in the art will appreciate, however, that embodiments of the disclosure are not limited to applications with stencil printers, but may also be applicable to other types of equipment used to deposit materials onto electronic substrates. For example, the principles disclosed herein may be applied to a dispenser used to dispense viscous materials onto printed circuit boards. In addition, although solder paste is referenced as being an exemplary material, other materials, such as adhesives, epoxies, underfill materials and encapsulant materials, may be deposited as well. Also, the terms screen and stencil may be used interchangeably herein to describe a device in a printer that defines a pattern to be printed onto a substrate.

Referring now to the drawings, and more particularly to FIG. 1, there is generally indicated at 10 a stencil printer of an embodiment of the disclosure. As shown, the stencil printer 10 includes a frame 12 that supports components of the stencil printer. The components of the stencil printer may include, in part, a controller 14, a display 16, a stencil 18, and a print head assembly or print head, generally indicated at 20, configured to apply the solder paste. As shown in FIG. 1 and described below, the stencil and the print head may be suitably coupled or otherwise connected to the frame 12. In one embodiment, the print head 20 may be mounted on a print head gantry 22, which may be mounted on the frame 12. The gantry 22 enables the print head 20 to be moved in the y-axis direction under the control of the controller 14. As described below in further detail, the print head 20 may be placed over the stencil 18 and a front or rear squeegee blade of the print head may be lowered in the z-axis direction into contact with the stencil. The print head 20 then may be moved by means of the gantry 22 across the stencil 18 to allow printing of solder paste onto a circuit board.

Stencil printer 10 may also include a conveyor system having rails 24, 26 for transporting a printed circuit board (sometimes referred to as a "printed wiring board," "substrate" or "electronic substrate") to a print position in the stencil printer. The rails 24, 26 may be referred to herein as a "tractor feed mechanism," which is configured to feed, load or otherwise deliver circuit boards to the working area of the stencil printer. The stencil printer 10 has a support assembly 28 to support the circuit board, which, as will be described in greater detail below, raises and secures the circuit board so that it is stable during a print operation. In certain embodiments, the substrate support assembly 28 may further include a particular substrate support system, e.g., a solid support, a plurality of pins or flexible tooling, which is positioned beneath the circuit board when the circuit board is in the print position. The substrate support system may be used, in part, to support the interior regions of the circuit board to prevent flexing or warping of the circuit board during the print operation. Embodiments of the substrate support system will be described in greater detail below.

In one embodiment, the print head 20 may be configured to receive solder from a source, such as a dispenser, e.g., a solder paste cartridge, that provides solder paste to the print head during the print operation. Other methods of supplying solder paste may be employed in place of the cartridge. Additionally, in a certain embodiment, the controller 14 may be configured to use a personal computer having a Microsoft DOS or Windows XP operating system with application specific software to control the operation of the stencil printer 10. In other embodiments, the operating system may utilize Lynix software or be embedded. The controller 14 may be networked with a master controller that is part of a line for fabricating circuit boards. In one configuration, the stencil printer 10 operates as follows. A circuit board is loaded into the stencil printer 10 using the conveyor rails 24, 26. The support assembly 28 raises and secures the circuit board to a print position. The print head 20 then lowers the desired squeegee blade of the print head in the z-axis direction until squeegee blade of the print head contacts the stencil 18. The print head 20 is then moved in the y-axis direction across the stencil 18. The print head 20 deposits solder paste through apertures in the stencil 18 and onto the circuit board. Once the print head has traversed the stencil 18 so that solder paste is deposited on the circuit board, the squeegee blade is lifted off the stencil and the circuit board is lowered back onto the conveyor rails 24, 26. The circuit board is released and transported from the stencil printer 10 so that a second circuit board may be loaded into the stencil printer. To print on the second circuit board, the other squeegee blade is lowered in the z-axis direction into contact with the stencil and the print head 20 is moved across the stencil 18 in the direction opposite to that used for the first circuit board. Still referring to FIG. 1 ,an imaging system 30 may be provided for the purposes of aligning the stencil 18 with the circuit board prior to printing and to inspect the circuit board after printing. In one embodiment, the imaging system 30 may be disposed between the stencil 18 and the support assembly 28 upon which a circuit board is supported. The imaging system 30 is coupled to an imaging gantry 32 to move the imaging system. In one embodiment, the imaging gantry 32 may be coupled to the frame 12, and includes a beam 34 that extends between the frame 12 to provide back and forth movement of the imaging system 30 over the circuit board in a y-axis direction. The imaging gantry 32 further includes a carriage device 36, which houses the imaging system 30, and is configured to move along the length of the beam 34 in an x-axis direction. The construction of the imaging gantry 32 used to move the imaging system 30 is well known in the art of solder paste printing. The arrangement is such that the imaging system 30 may be located at any position below the stencil 18 and above the circuit board to capture an image of predefined areas of the circuit board or the stencil, respectively. In other embodiments, when positioning the imaging system outside the print position, which is sometimes referred to as the "print nest," the imaging system may be located above or below the stencil and the circuit board.

Exemplary platforms for performing print operations may include and are not limited to the ACCELA® and MOMENTUM® stencil printers offered by Speedline Technologies, Inc. of Franklin, Massachusetts, the assignee of the present disclosure.

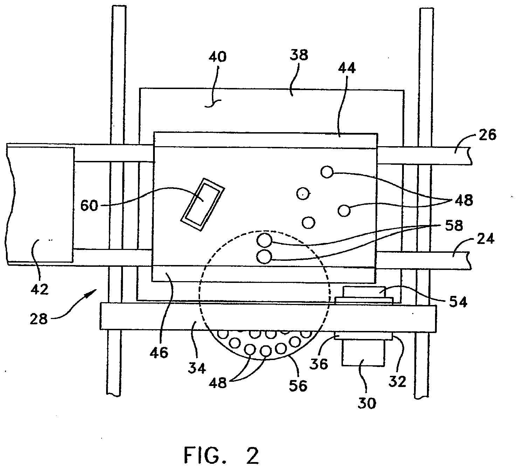

Turning now to FIG. 2, the support assembly 28 is schematically illustrated to show relevant components of the assembly to be discussed herein. Specifically, the support assembly 28 includes a table 38, which is suitably coupled to the frame 12. The table 38 includes a top support surface 40 configured to support a plurality of support elements that are used to support a printed circuit board 42 when in a print position. The table 38 may include a pair of rails 44, 46 that are configured to engage and secure the printed circuit board 42 when performing a print operation on the circuit board. In some embodiments, the rails 44, 46 may include clamping members (not shown), such as the clamping members disclosed in U.S. Patent No. 7,121,199 to Perault et al., which discloses a substrate supporting and clamping system. The arrangement is such that a printed circuit board 42 is loaded onto the table 38 by rails 24, 26 and shuttled to the print nest located above the table 38. Rails 44, 46 may be configured to secure the circuit board 42 in a fixed position so that a stencil printing operation may be performed on the circuit board. After the print operation, the circuit board 42 is unloaded by rails 24, 26. After which, the process repeats with another circuit board being loaded onto the table 38 by rails 24, 26 and shuttled to the print nest so that a print operation may be performed on the circuit board.

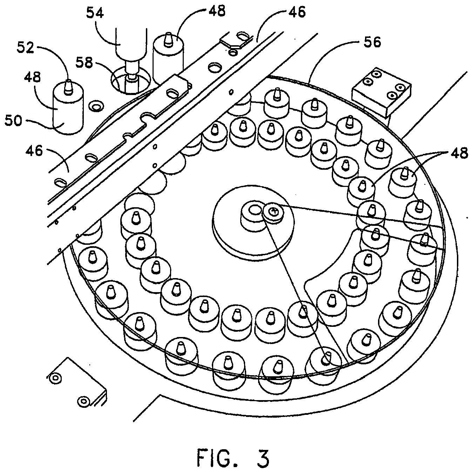

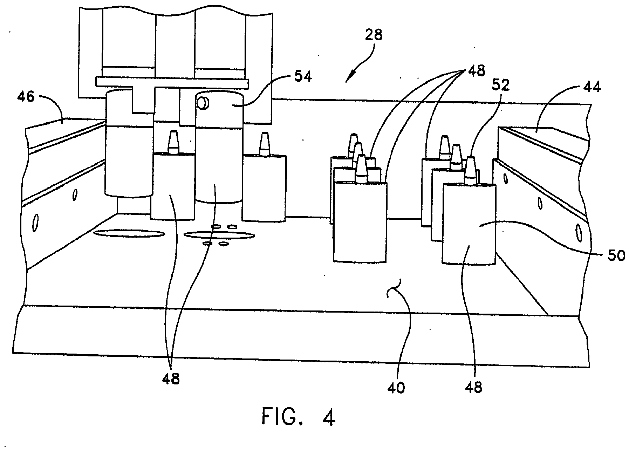

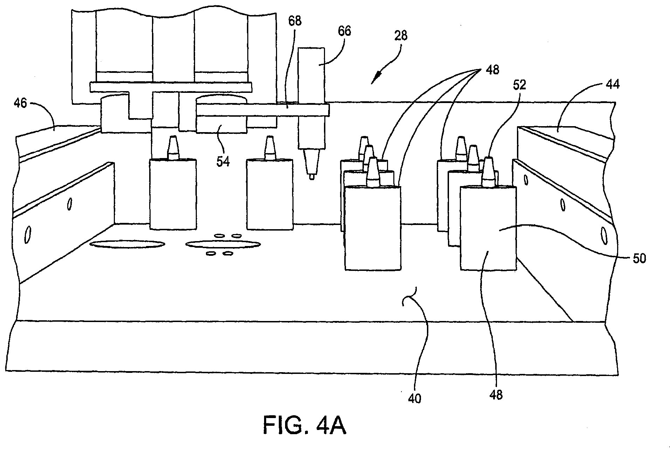

With reference to FIGS. 2-4A, in one embodiment, the substrate support assembly 28 further includes a plurality of support elements, such as pins, each indicated at 48, which are supported on the top surface 40 of the table 38 in predetermined locations to be described in particular detail below. As shown in FIGS. 3 and 4, each pin 48 includes a cylindrical base 50 and a tapered head 52, which is configured to support the circuit board when placing the circuit board on top of the pin. Specifically, the arrangement is such that the head 50 of each pin 46, which is shown as having a flattened top portion, supports the under- or bottom surface of the circuit board 42 at locations that are unoccupied by components mounted thereon. Pins 48 may be placed at variable predetermined locations on the table 38 by a pin placement head 54, which is mounted on the carriage device 36 of the imaging gantry 32. As discussed above, the placement head 54 is movable in a first direction (e.g., an x-axis direction) by means of the carriage device 36 as it moves along the length of the beam 34 and in a second direction (e.g., a y-axis direction) by means of the beam as it moves along the length of the frame 12. In certain embodiments, the placement head 54 is at a higher elevation than the table 38 and is movable over the rails 44, 46 of the table to engage the pins 48.

As shown in FIGS. 2 and 3, the pins 48 are dispensed by a supply tray 56, which is located on a tray support (not shown) under the table 38. The supply tray 56 is rotatable about an axis to deliver pins 48 to one of two openings, each indicated at 58, formed in the table 38. The arrangement is such that each pin 48 may be secured by the placement head 54 through one of two openings formed in the table for positioning by the placement head on a predetermined location on the table 38. The placement head may include a z-axis drive mechanism to lower the placement head so that it may pick up a pin 48 for placement. In one embodiment, the placement head 54 may include a magnetic system to releasably secure the pin 48 to the placement head. In another embodiment, the placement head 54 may include a vacuum system to secure the pin 48. Once secured, the placement head is configured to move along the beam 34 and along the frame 12 to position the placement head over a predetermined position on the table 38 to deposit the pin 48 on the table. The placement head 54 may employ the z-axis drive mechanism to lower the placement head to deposit the pin 48 on the top surface 40 of the table 38. The pin 48 may be securely positioned on the table 38 by means of a magnet housed within the base 50 of the pin, which provides a magnetic attraction of the pin to the metal table. In other embodiments, a vacuum system may be employed to secure the pins 48 on the table 38.

In other embodiments, the support elements may include a support system disclosed in U.S. Patent No. 7,028,391 to Pham-Van-Diep, et al., which is incorporated herein by reference in its entirety for all purposes. Specifically, the support system may include tooling sold under the brand name Gel-Flex® by Speedline Technologies, Inc. of Franklin, Massachusetts. This gel-based technology, designated 60 in FIG. 2, may include a polyurethane elastomer gel that is enclosed within a durable membrane shell and mounted to a magnetic base. The compressible gel material may provide gentle compliance to delicate bottom-side components and leads while providing firm support for the entire board surface. Although not shown, the stencil printer 10 may include motors and actuators that, along with the controller 14, cause the movement of the placement head 54 and the supply tray 56. The stencil printer 10 may also include additional sensors beyond those required to control accurate movement of the components described herein. In particular, the imaging gantry 32 and the placement head 54 may be moved (by means of the carriage device 36) to precisely position a pin 48 at any x, y coordinate location on the table to within predetermined tolerances, so long as the location does not cause interference with rails 44, 46 or previously placed pins. The controller 14 may include a processor, memory for storage data and control programs to carry out the programmed procedures described herein. Also, with reference to FIG. 1, the display 16 may be accompanied by interactive user inputs including a keyboard 62 and a mouse 64 that are used to manipulate the controller 14.

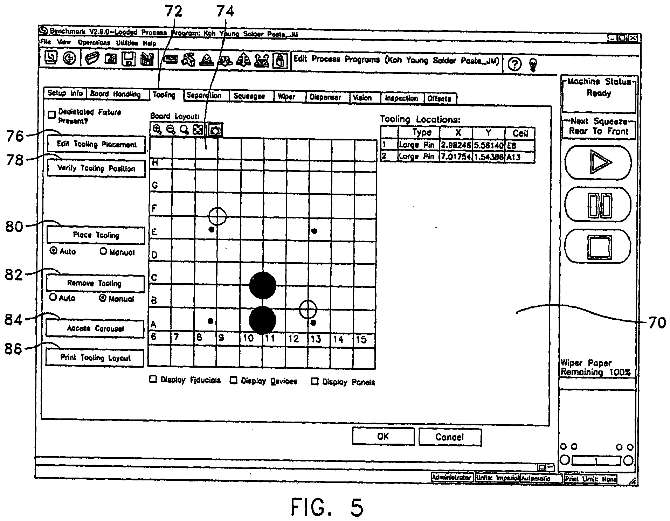

It should be understood that other pin placement systems, such as the type disclosed in U.S. Patent No. 5,794,329 to Rossmeisl et al., which is incorporated herein by reference for all purposes, may be employed to move the pins to predetermined locations, and still fall within the scope of the instant disclosure. In certain embodiments, as described above, the operator of the stencil printer 10 may manipulate the operation of the pin placement system by means of the mouse 64, keyboard 62 and the display 16 via the controller 14. Specifically, the display 16 may be configured to show a screen display that permits the operator to operate the pin placement system. As shown in FIG. 5, which illustrates a screen display 70 of an embodiment of the disclosure, the pin placement system 54 may be operated under the "Tooling" tab 72, which may be provided as one of a plurality of tabs used to operate the stencil printer. As shown, the locations for placing the pins may be manipulated by using an edit mode. Specifically, the screen display 70 may include a number of buttons provided on the left-hand side of the screen display and a display of a board area 74 indicating the area to be occupied by a circuit board on the table, which is centrally located on the screen display. As shown, scales for the x-axis and y-axis coordinate axes are adjacent to board area 74, and the origin is at the bottom left-hand corner of board area. The display of board area 74 may also include horizontal borders provided above and below the board area to identify the areas at the top and bottom of the board in which pins cannot be located because they would otherwise interfere with the edge of rails 44, 46. The board area 74 may also include side borders that define areas in which pins are required not to be placed owing to other constraints provided on the sides of the board area 74. The size and orientation of the board area 74 may be automatically determined in a set-up mode in which the operator inputs information as to the size of the actual circuit board and other information. Also shown on the board area 74 are the two openings 58 as well as reference points and exemplary pin placement locations.

As shown, the buttons are provided for editing the tooling placement ("Edit Tooling Placement" button 76), verifying tooling position ("Verify Tooling Position" button 78), placing tooling ("Place Tooling" button 80), removing tooling ("Remove Tooling" button 82), accessing the tooling carousel ("Access Carousel" button 84), and printing the tooling layout ("Print Tooling Layout" 86). Other buttons may also be included within the buttons. For example, although not shown, within the edit tooling placement feature, an "add" button, which along with the other buttons, may be activated using the mouse and keyboard user input devices. In certain embodiments, the "add" button may be used to activate the add feature in which the operator adds pins to the board area by moving the cursor to the desired location and clicking on the location. As the cursor is moved, the x and y position coordinates may be automatically updated on screen, which may also display the file name, the pin count and the pin ID number. The pin count is the total number of selected pins as shown on the board area. The pin ID number identifies the position in the selection sequence in which the pin was originally selected. The pin ID number may also indicate the order in which the pins will be placed on board unless the order is modified by the operator or the automated optimization procedures described below. Pins can be removed from the board area using the "Remove Tooling" button 82 to activate the remove function either automatically or manually.

While in the edit mode, the operator may activate a display option, which lists the coordinates of the pins in the order that they will be placed. In addition, the operator may select an option to have the pins sequentially appear on the board area in order in which they will be placed on the board.

After the selected positions have been entered using the screen displays, or by importing location information from an external file, the operator can activate optimization modules of the software in order to avoid collisions when moving the pins and to reduce the time spent by the placement head in placing pins by reducing the distances that the placement head must move during a placement operation. Before running, the controller 14 may verify the validity of pin coordinates by performing a boundary check sequence to confirm that pins are not specified for placement in areas in which pins cannot be placed owing to constraints of the placement equipment, an overlap check to confirm that pins are not specified for placement in overlapping areas, and a total number of pin check to confirm that a maximum pin limit is not exceeded by the specified pins.

The display 16 may be configured to include the "Verify Tooling Position" button 78, which may cause pins 48 to be sequentially shown on the board area 74 in the order in which they will be placed on the table 38 by the placement head 54. The "Place Tooling" button 80 may then cause the placement head 54 to begin its placement procedure. As shown, the pins 48 may be automatically placed on the table 38 or placed manually on the table. As the pins 48 are placed, they are displayed on the board area 74, and the coordinates of the pins may be displayed along with the elapsed time, the percentage placed, and the numbers that have been placed. In certain embodiments, the operator may select to run in a "continuous" mode in which the placement head 54 runs at full speed to place the pins in the optimum minimum time. The operator may also select to run in a "step" mode in which the stencil printer is advanced one step at a time and stops, and the operator must initiate the next step. The "step" mode permits the operator to view the placement procedure for trouble shooting and educational purposes. In operation, the supply tray 56 may be loaded with pins 48 by engaging the "Access Carousel" button. It should be noted that the supply tray 56 may sometimes be referred to herein as a "carousel." After loading, pins 48 are delivered to the openings 58 in the table 38 by rotating the supply tray 56. Pins 48 are sequentially secured by the placement head 54 and automatically deposited in predetermined locations on the top surface 40 of the table 38. Specifically, when a pin 48 is secured by the placement head 54, the placement head is moved by the imaging gantry 32 in the y-axis direction and by the carriage device 36 in the x-axis direction until the pin is located above the desired position on the table 38. The z-axis drive mechanism may be employed to lower the pin 48 on the table 48. After placing the pin 48, the placement head 54 may be configured to return over one of the openings 58 to secure a new pin for placement.

After pins 48 have been placed at the desired positions on the table 38, the circuit board 42 is moved over the tractor mechanism to the desired location and supported on pins by lowering the circuit board relative to the table or by raising the table to the circuit board. When it is desired to change the pattern of pins, in one embodiment, the pins may be cleared from the upper surface of the table 38 by activating the "Remove Tooling" button 82 as described above. In one embodiment, a sweeper or some other device (not shown) may be provided and moved across the table 38 to sweep away the pins 48 off the table. The cleared pins 48 may be collected in a container (not shown). A sensor (not shown) may be provided to detect the presence of the container, wherein the sensor may be further configured to detect when the container is full with pins. In another embodiment, the placement head 54 may be employed to remove the pins 48 and place them back into the supply tray 56.

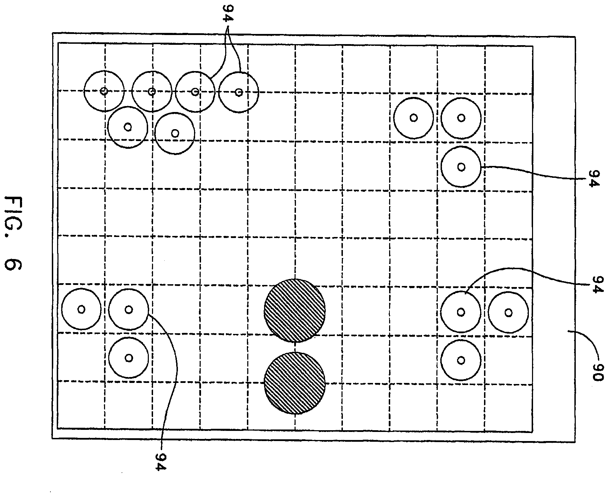

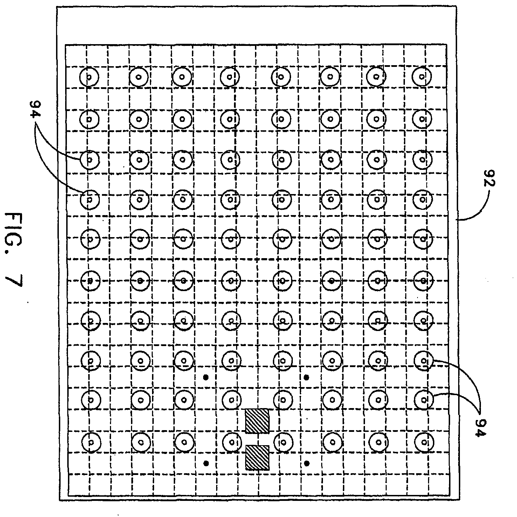

Referring to FIGS. 6 and 7, templates 90, 92, respectively, may be generated by the controller to place on the table when manually placing pins on the table. FIG. 6 illustrates one pin placement template 90 having a plurality of markings 94 designating locations for pin placement. FIG. 7 illustrates another pin placement template 92 also having a plurality of markings designating locations for pin placement. The templates 90 or 92 may be suitably secured to the table 38 (e.g., by adhesive or tape) prior to positioning the pins 48 (or other tooling) on the markings 94.

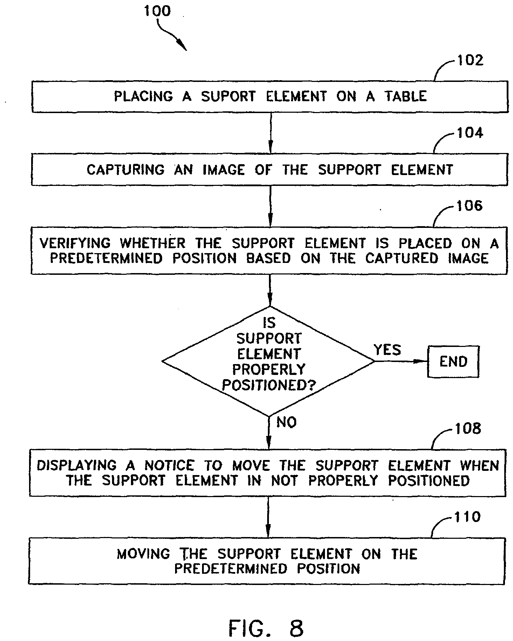

FIG. 8 illustrates an exemplary method 100 for verifying an accurate placement of pins on the table. As shown, the method 100 includes placing at least one pin (or other support element as described herein) on the support surface of the table in a predetermined position at 102. Next, an image is captured of the pin at 104. After capturing the image, the controller verifies whether the pin is placed on the predetermined position based on the captured image at 106. If no movement is required, the verification routine ends. If movement is required, a notice is displayed on the display to move the pin when the pin is not properly positioned at 108. In further embodiments, the pin is moved by means of the placement head or manually to the predetermined position at 110.

In other embodiments, the method 100 may further include manually placing the pins on a side of the table, and moving the pins with a placement tool of the stencil printer to the predetermined positions. In a particular embodiment, manually placing the pins includes placing a predetermined number of pins. The method may further include counting the pins to verify whether the number of pins equals the predetermined number.

It should be noted that the controller 14 may be configured to perform multiple operations. Further, the controller 14 may be configured with a computer readable medium having stored thereon sequences of instruction including instructions that will cause the processor to perform multiple functions. For example, in one embodiment, the controller 14 may be configured with a pin location verification routine, which allows the stencil printer to verify that a pin is in its proper position. The pin location verification routine may be a software-implemented routine that allows the machine to verify that the pin is in proper position. During the operation of the stencil printer, an operator manually loading circuit boards may disrupt the pins. A typical approach to resolve this problem was to remove all the pins and then place them accurately again, which may take too much time. Using the methods disclosed herein, the imaging system, under the control of the controller, may check the location of all of the pins to verify whether the pins are in the proper locations. In a situation where a pin is out of position, the stencil printer may prompt the operator to reposition the pin and continue to monitor the pin position and advise via the display of further repositioning needs until it is verified that the pin is in its proper position. In certain embodiments, the placement head may be manipulated to move the pin to its proper position. In other embodiments, the operator would manually place the pins in a rough location, and the stencil printer, by means of the imaging system and the pin placement head, would find these pins and place them in their proper, precise location. In addition, the stencil printer may be configured to advise the operator by means of the display to manually move or alter the pin position.

In one embodiment, the stencil printer operator may manually place a predetermined number of pins in a designated location on the table, e.g., against the top rail 44 which is temporarily opened to accept a larger size board. Thus, with this embodiment, the supply tray would not be part of the pin placement system. The stencil printer may be configured to know the storage location of the pins, find them, and place the pins by means of the pin placement head in proper predetermined locations, while also verifying that an operator did not accidentally place an incorrect amount of pins in the storage location. Accordingly, with this embodiment, the controller 14 may be configured to determine that a proper number of pins are supplied and that the pins are placed accurately in predetermined locations. As discussed above, in certain embodiments, the stencil printer may not be equipped with the automatic pin placement system of embodiments of this disclosure. In such configurations, the operator may print out a paper template for pin placement, such as the templates 90, 92 illustrated in FIGS. 6 and 7, respectively. The controller 14 may be configured so that this feature is imbedded in the code and the operator would only need to have a printer to print the template to a proper scale. The arrangement is such that pins may be placed on top of the template manually and be left in position or adjusted manually or automatically by the verification routine. Specifically, the imaging system 30 may be manipulated to capture an image of the pins 48. The location of the pins 48 may be displayed on the display 16, whereby the operator may then manually or automatically manipulate the pins to their proper locations.

In another embodiment, the pin placement system may be automated to mark locations on a template provided on the table or on the table directly for manual pin placement by the operator. The imaging gantry 32 may be configured to house a device in place of or in addition to the placement head 54 for marking the table 38 for the appropriate location of a manually placed pin. For example, FIG. 4A illustrates a marking device 66 secured to the placement head 54 by a bracket or clip 68. When marking the table, pins may be placed on or near the markings and be left in position or adjusted by the verification routine. Methods for marking the table may include writing on the table with a felt-tipped pen that is housed by the imaging gantry, or by using a laser pointer to indicate the position and marking the position manually. More complicated approaches, such as thin films that temporarily retain writing, may also be implemented.

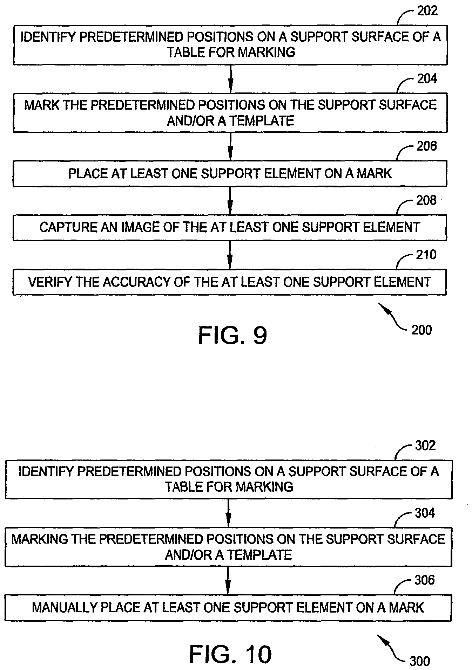

With reference to FIG. 9 a method of marking a support surface of a table of an apparatus configured to deposit material on an electronic substrate and verifying the accuracy of the marks is generally indicated at 200. In one embodiment, the method 200 comprises: identifying predetermined positions on the support surface of the table for marking at 202; marking the support surface of the table on the predetermined positions at 204; manually (or automatically) placing at least one support element on a mark at 206; capturing an image of the at least one support element at 208; and verifying whether the support elements are accurately placed on the predetermined positions on the support surface of the table based on the image captured by the imaging system at 210. In some embodiments, when identifying the predetermined positions on a support surface, the positions may be selected from existing data provided to the controller 14. The method may further comprise marking a template configured to be placed on the support surface of the table and using an automated marking device coupled to the apparatus. With reference to FIGS. 4 and 4A, the automated marking device may be a marker that is attached to or replaces the placement head 54.

With reference to FIG. 10, a method of marking a support surface of a table of an apparatus configured to deposit material on an electronic substrate and verifying the accuracy of the marks is generally indicated at 300. In one embodiment, the method 300 comprises: identifying predetermined positions on the support surface of the table for marking at 302; marking the support surface of the table on the predetermined positions at 304; and manually placing one ore more support elements on or near the marks at 306. In another embodiment, the method may further comprise placing a template having markings on the support surface of the table. As with the method shown in FIG. 9, the positions for marking the surface may be provided from existing data provided to the controller.

In one embodiment, the controller 14 may be configured to verify whether non-standard tooling is placed on the table, and whether the non-standard tooling is properly placed. As discussed herein, there are several types of tooling available at the time of this disclosure. For example, support elements, such as pins, basic support blocks and gel tooling blocks, are available in a number of sizes, such as 2X2, 2X4 and 4X4, which are known in the art. With this routine, the software may be manipulated to allow for the unique nature of the particular tooling provided, and to verify that the tooling is placed properly on the table. The operator may be prompted to alter their placement of these particular tooling items as well as to verify their proper placement.

In one embodiment, instead of providing the supply tray, which is a relatively complex mechanism for storing pins, the pins would be placed on a shelf in front of one of the two rails 44, 46, e.g., the front fixed rail 46 (i.e., the rail adjacent the front of the stencil printer). The imaging system may be configured to find the pins and the pin placement head may be configured to lift them over the front fixed rail. Once secured by the pin placement head, the pin may be deposited in its proper position. The pin placement head may also be configured to return the pins to the storage shelf after verifying that there are no pins in the locations where it intends to store them. In one particular embodiment, the pin may not be moved over the fixed rail. However, to achieve this function, the controller 14 may be manipulated to have the pin placement head lift the pin higher along a z-axis. Alternatively, the support surface could be lowered. In another embodiment, instead of using the supply tray for storing pins, the pins would be placed in a rack and when required, the rack of pins may be placed between the rails. The imaging system may then be able to obtain an image of the pins, pick up the pins with the pin placement head, and place these pins as well as put them back in the rack as necessary.

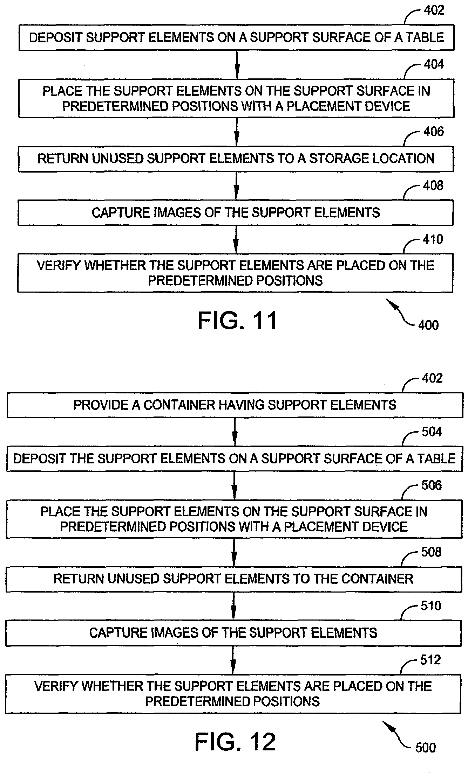

Referring to FIG. 11, a method of placing and verifying an accurate placement of a support element on a support surface of a table of an apparatus configured to deposit material on an electronic substrate is generally indicated at 400. In a certain embodiment, the method 400 comprises: depositing one or more support elements on the support surface of the table at 402; placing support elements on the support surface of the table in predetermined positions with a placement device at 404; returning unused support elements to a storage location at 406; capturing an image of the support elements disposed on the support surface of the table at 408; and verifying whether the support elements are placed on the predetermined positions on the support surface of the table based on the captured image at 410. In one embodiment, the storage location may be against a rail or a loading/unloading rack that is disposed on the support surface away from where the electronic substrate is processed. Turning now to FIG. 12, a method of placing a plurality of support elements on a support surface of a table of an apparatus configured to deposit material on an electronic substrate is generally indicated at 500. In at least one embodiment, the method 500 comprises: providing a container having support elements at 502; depositing the support elements on the support surface of the table at 504; placing the support elements on the support surface of the table in predetermined positions with a placement device at 506; returning unused support elements to the container at 508; capturing at least one image of the support elements at 510; and verifying whether the support elements are placed on the predetermined positions at 512.

In a particular embodiment, data obtained from an external resource, such as CAD data, may be utilized to define pin locations. Specifically, raw CAD data may be digested off line and keep out zones may be utilized for automated identification of desired pin locations and for optimization of pin locations. In another embodiment, the software may be configured with an interface to obtain raw board Gerber data. The software interface may be customized for interpretation of raw Gerber data and the analysis of pin placement possibilities. The operator may be prompted to enter pin placement requirements and the software may be configured to make a recommendation on pin placement for the operator to accept or refuse. In yet another embodiment, the data may be taken from a third party source, such as data taken from a pick-and-place machine provided in the printed circuit board assembly line.

As shown, there are many ways of importing data used for pin placement requirements. The examples provided herein are not meant to be limiting.

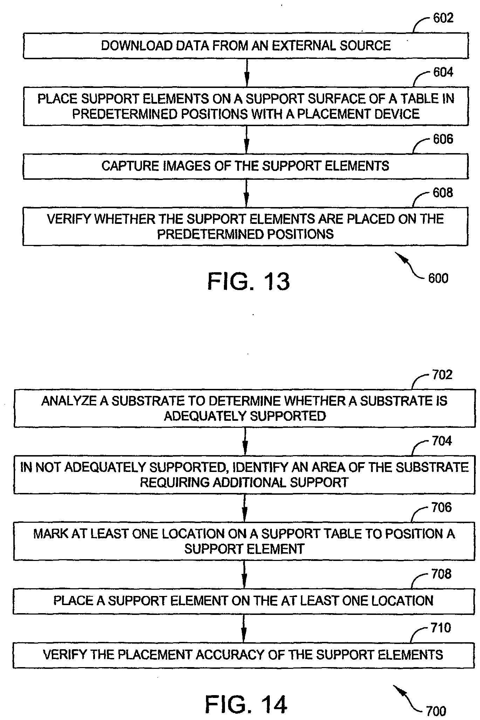

With reference to FIG. 13, a method of placing support elements on a support surface of a table of an apparatus configured to deposit material on an electronic substrate is generally indicated at 600. Embodiments of the method 600 comprise: downloading data from an external source, with the data providing information related to the positioning of support elements on the support surface of the table at 602; placing the support elements on the support surface of the table in predetermined positions with a placement device based on the downloaded data at 604; capturing at least one image of the support elements disposed on the support surface of the table at 606; and verifying whether at least some of the support elements are placed on the predetermined positions on the support surface of the table based on the at least one image captured at 608.

In one embodiment, when performing a board changeover, which requires the tooling to be repositioned on the table, and/or tooling to be added to or removed from the table, the software may be configured to prompt the operator for manual placement of specific tooling devices, such as pins. This prompt may include: (1) identifying a specific area for the tooling device by using the imaging system; (2) marking and/or laser pointing the placement location; and (3) verifying the placement accuracy as well as prompting for any necessary position correction. In another embodiment, the software may be typically configured to place pins for new boards by working from an outward position to an inward to avoid pin collision. Stated another way, the software may be configured to operate to place pins from the periphery of the table inwardly. This approach means that for configuration changes, the entire table needs to be cleared of any pins, and that all new pins need to be replaced. The software may be configured to include pin path travel analysis capabilities to optimize pin placement. This optimization feature may enable the pin placement to be more rapidly converted for new products in which pins may be added within an established grid pattern without time consuming reconfiguration. Specifically, pins may be placed faster and with maximum density, while avoiding pin collisions during the placement process.

In yet another embodiment, in instances where the support tooling is insufficient to properly support the circuit board, the circuit board will sag under the pressure of the print process. In this particular instance, there may be bridging of excessive paste between adj acent print features. In one embodiment, the software may be configured to perform two-dimensional and/or three-dimensional print analysis, and to analyze the print results and compare the print results to known data to determine whether there is insufficient tooling in specific areas beneath the circuit board. The software may also be configured to make recommendations to place pins in certain areas based upon detected problem areas as well as potential areas where a pin or other tooling device could fit. In another embodiment, the software may be configured to utilize a closed loop squeegee to determine if pin placement problems exist. Specifically, a closed loop squeegee may be employed to maintain constant print pressure regardless of variations in the top surface of the circuit board. Large squeegee moves may be required to maintain a desired squeegee pressure. As a result, increased pressure, which may be set by the operator, may cause a circuit board to bow beneath the squeegee. The software may be configured to monitor the print pressure applied by the squeegee as well as required squeegee z-axis motion, and use this information to provide feed back recommendations for pin placement changes, including moving pins, adding pins, and removing pins, that may improve the level of support beneath the circuit board.

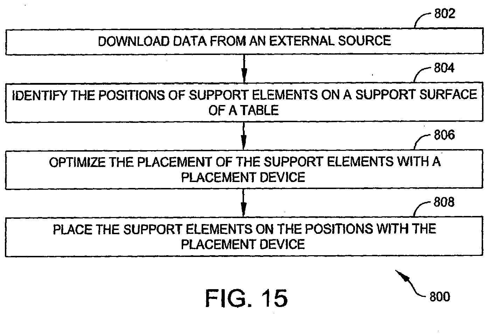

Turning to FIG. 14, a method for supporting a substrate within an apparatus configured to deposit material on the substrate is generally indicated at 700. In an embodiment, the method 700 comprises: analyzing a substrate to determine whether the substrate is properly supported at 702; if not properly supported, identifying an area of the substrate requiring additional or less support at 704; marking at least one location on a support table to position a support element at 706; placing a support element on the location at 708 of removing a support element; and verifying the placement accuracy of the support element at 710. There may be instances in which there is too much support. For example, a support pin may migrate under a component lead. In such an example, the pin may be moved or removed. In one embodiment, the substrate may be analyzed by subjecting the substrate to a 2D or a 3D analysis that is commonly used for determining the existence of bridging between pads. In another embodiment, the bottom of the stencil may be analyzed for paste that has bled out due to lack of a gasket effect between the substrate and the stencil. This effect is caused by a lack of adequate support of the substrate. When marking the substrate, the at least one location is identified. In a particular embodiment, the identification of the area requiring additional support and the verification of the placement accuracy may be performed with an imaging system. In certain embodiments, and with reference to FIG. 15, a method of placing support elements on a support surface of a table of an apparatus configured to deposit material on an electronic substrate is generally indicated at 800. The method may comprise: downloading data from an external source, the data providing information related to the positions of the support elements on the support surface of the table at 802; identifying the positions of support elements on the support surface of the table at 804; optimizing the placement of the support elements on the support surface of the table with a placement device at 806; and placing the support elements on the positions of the support surface of the table with the placement device at 808. In certain embodiments, while the controller may be configured to recommend placement of the support elements, the operator may still be required to accept the locations recommended. The operator may choose to reject a location for a specified reason. In such an instance, the controller may be configured to recommend another location.

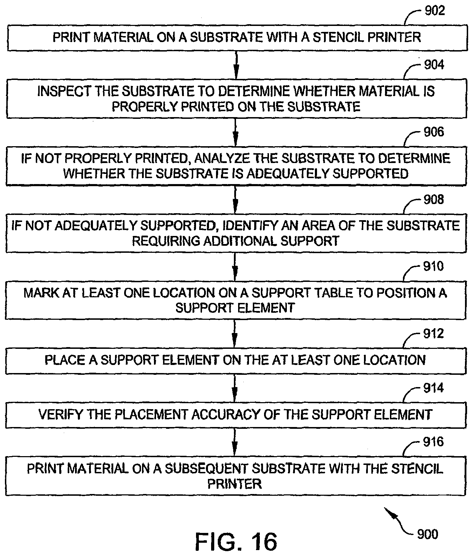

With reference to FIG. 16, a method for printing material on a substrate is generally indicated at 900. In one embodiment, the method comprises: printing material on the substrate with a stencil printer at 902; inspecting the substrate to determine whether material is properly printed on the substrate at 904; if not properly printed, analyzing the substrate to determine whether the substrate is properly supported at 906; if not properly supported, identifying an area of the substrate requiring additional or less support at 908; marking at least one location on a support table to position a support element at 910; placing a support element on the at least one location at 912 or removing a support element; verifying the placement accuracy of the support element at 914; and printing material on a subsequent substrate with the stencil printer at 916. There may be instances in which there is too much support. For example, a support pin may migrate under a component lead. In such an example, the pin may be moved or removed. In a particular embodiment, the identification of the area of the substrate and the verification of the placement accuracy may be performed with an imaging system.

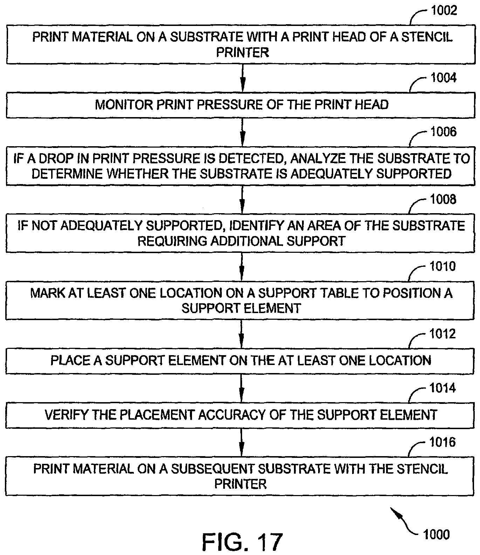

Referring to FIG. 17, a method for printing material on a substrate is generally indicated at 1000. Embodiments of the method comprise: printing material on the substrate with a print head of a stencil printer at 1002; monitoring print pressure of the print head at 1004; if a drop or a rise in print pressure is detected, analyzing the substrate to determine whether the substrate is properly supported at 1006; if not properly supported, identifying an area of the substrate requiring additional or less support at 1008; marking at least one location on a support table to position a support element at 1010; placing a support element on the location at 1012 or removing a support element; verifying the placement accuracy of the support element at 1014; and printing material on a subsequent substrate with the stencil printer at 1016. There may be instances in which there is too much support. For example, a support pin may migrate under a component lead. In such an example, the pin may be moved or removed. Embodiments of this method may be achieved by using a stencil printer having a closed-loop print head having a force sensing capability. In most operations, the height of the print head may be adjusted when sensing too much or too little pressure on the substrate. However, when monitoring drops or rises in pressure associated with improper substrate support, the print head height should remain constant.

In a certain embodiment, the imaging system may be employed to determine tooling placement options. Specifically, a circuit board may be brought into the stencil printer upside down and scanned by the imaging system. The software may be configured to stitch images of the bottom surface of the circuit board together and invert the images so that the operator may see the component layout on the bottom surface of the circuit board as if the circuit board were transparent. In another embodiment, images may be taken from below the board to stitch images of the bottom surface of the circuit board. The operator may then decide on where to place the pins based on the information obtained. The software may be further configured to store both the pin grid array and the board picture for future reference. In another embodiment, a laser and the imaging system may be utilized to determine tooling placement options. For example, a circuit board may require printing on its top surface, but is delivered to the stencil printer with its bottom side facing upwardly, thereby exposing the populated bottom surface. A line laser may be used in conjunction with the imaging system to scan the circuit board. The changes in line position may be representative of the heights of the components populated on the bottom side of the circuit board. In other embodiments, confocal equipment and/or future height measurement devices may be used to scan the circuit board. As with the above embodiment, the software may be configured to stitch images of the bottom surface of the circuit board together and invert the images so that the operator may see the component layout on the bottom surface of the circuit board as if the circuit board were transparent. The software may then be configured to store both the pin grid array and the board picture for future reference.

In a particular embodiment, the imaging system may be employed to establish the desired pin heights and to set the heights of the pins placed on the table. Most often, pins having fixed pin heights are employed. Pins of an embodiment of the disclosure may be configured to have a variable height that may be adjusted and locked. The tool placement head may include a mechanism to grip the top of the pin and hold the pin in a fixed position while a z-axis movement takes place to either lift the head of the pin or retract the base of the pin thereby moving the body axially with respect to the head to achieve a predetermined height. In one embodiment, magnets may be used to lock the pins at their desired heights. A circuit board that is populated on the bottom surface and requires printing on the topside of the circuit board may be sent through the stencil printer with the bottom surface facing upwardly. A line laser may be employed in conjunction with the imaging system to scan the circuit board to determine the height of the components. The changes in line position may be representative of the height of the components. As described above, confocal equipment may be used to establish desired pin heights. In other embodiments, a mechanical device may be used to determine the heights of the pins. The software may be configured to stitch images of the bottom surface of the circuit board together and invert the images so that the operator may see the component layout on the bottom surface of the circuit board as if the circuit board were transparent. The pin placement software may further enable the operator to select pin locations below a device, and teach and set the heights of the pins that are needed beneath any specific component. In yet another embodiment, a tooling changer may be utilized with a series of different pin grippers to make use of a wider variety of pins since pins may be available with differing heights and diameters. The imaging system may be used to identify pin type and choose the appropriate gripper as necessary.

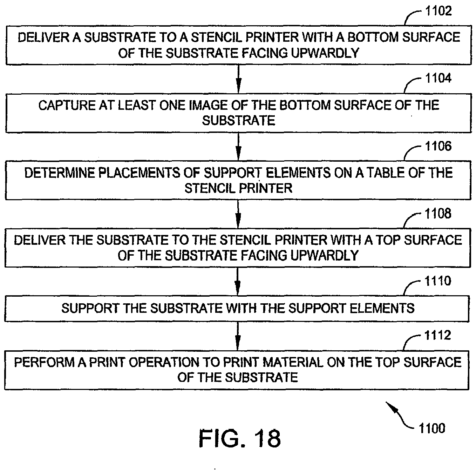

With reference to FIG. 18, a method of printing material on a top surface of a substrate of the type having a top surface and a bottom surface is generally indicated at 1100. In a certain embodiment, the method 1100 comprises: delivering a substrate to a stencil printer with the bottom surface of the substrate facing upwardly at 1102; capturing an image of the bottom surface of the substrate at 1104; determining the placement of support elements on a table of the stencil printer based on the image at 1106; delivering the substrate to the stencil printer with the top surface of the substrate facing upwardly at 1108; supporting the substrate with the support elements at 1110; and performing a print operation to print material on the top surface of the substrate at 1112.

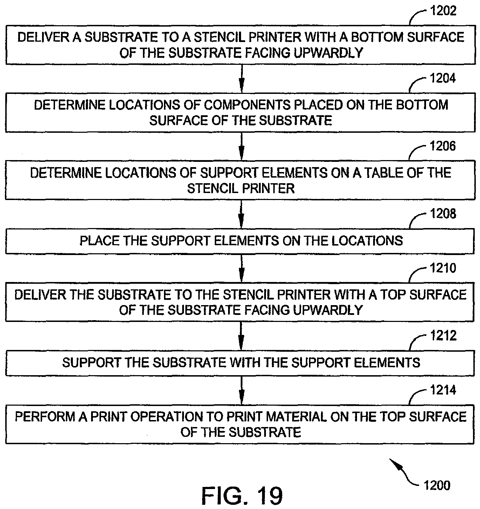

In another embodiment, as shown in FIG. 19, a method of printing material on a top surface of a substrate of the type having a top surface and a bottom surface is generally indicated at 1200. Embodiments of the method 1200 comprise: delivering a substrate to a stencil printer with the bottom surface of the substrate facing upwardly at 1202; determining the location of components placed on the bottom surface of the substrate at 1204; determining locations of support elements on a table of the stencil printer based on the determination of the location of components at 1206; placing the support elements on the locations at 1208; delivering the substrate to the stencil printer with the top surface of the substrate facing upwardly at 1210; supporting the substrate with the support elements at 1212; and performing a print operation to print material on the top surface of the substrate at 1214. In a certain embodiment, determining the location of components may comprise capturing an image of the bottom surface of the substrate to determine the position of the components, and using a laser to determine heights of components. As described above, confocal equipment may be used to establish desired pin heights.

It should be understood that any suitable method may be employed to set the pin heights. In addition to the methods described above, a focus technique may be used. In addition to the visual approaches described herein, a tactile sensor may be used. In other embodiments, a device may be used in conjunction with the Z-axis gantry that moves the imaging system, to determine support element heights. In addition, the height of each support element may be determined.

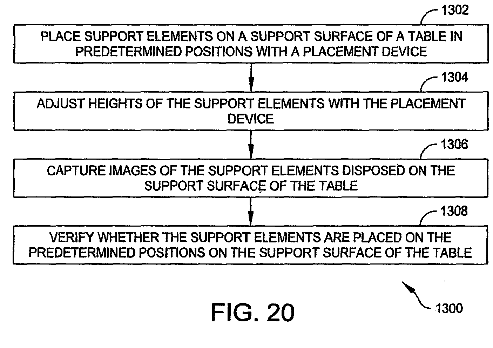

Turning now to FIG. 20, a method of placing support elements on a support surface of a table of an apparatus configured to deposit material on an electronic substrate is generally indicated at 1300. In an embodiment, the method 1300 comprises: placing support elements on the support surface of the table in predetermined positions with a placement device at 1302; adjusting heights of the support elements with the placement device at 1304; capturing an image of at least some of the support elements disposed on the support surface of the table at 1306; and verifying whether the support elements are placed on the predetermined positions on the support surface of the table based on the captured image at 1308. The method may further include verifying the heights of the support elements with a device, such as the imaging system.

It should be understood that methods 200-1300 are simplified and in actual practice any method described herein may contain additional steps or the steps that are described may be performed in a different sequence unless otherwise specified.

As discussed herein, the principles may be employed in other apparatus requiring tooling to support a substrate so that an operation may be performed on the substrate. For example, the principles taught herein may be employed on dispensers that are capable of dispensing a wide variety of materials onto a substrate, such as a printed circuit board or a semiconductor wafer.

It should be understood that embodiments of the methods and apparatus disclosed herein may be employed to perform pin placement operations in apparatus not having inspection systems. For example, when utilizing Gerber data, this information may be processed and configured by the controller to move the pin placement head to perform pin placement operations. In one embodiment, the operator may be prompted to enter pin placement requirements and the software may be configured to make a recommendation on pin placement for the operator to accept or refuse.

As used herein, when referencing whether a support element is placed on a predetermined position, it should be understood that the support element is placed on a predetermined position within an acceptable tolerance defined by the operator or the controller. In addition, there may be many methods available to verify the accuracy of a support pin position on the table. For example, the imaging system may be used. In another embodiment, the operator may manually inspect the accuracy of the support pin placement. In some applications, a glass template with marks formed thereon may be used to enable an operator to inspect the accuracy of pin placement.

Having thus described several aspects of at least one embodiment of this disclosure, it is to be appreciated various alterations, modifications, and improvements will readily occur to those skilled in the art. Such alterations, modifications, and improvements are intended to be part of this disclosure, and are intended to be within the spirit and scope of the disclosure. For example, the parameters described herein may be modified to accommodate different printing process requirements. Accordingly, the foregoing description and drawings are by way of example only.

## Claims

1. A method of placing a plurality of support elements on a support surface of a table of an apparatus configured to deposit material on an electronic substrate, the method comprising: providing a container having a plurality of support elements; depositing the plurality of support elements on the support surface of the table; and placing at least one support element of the plurality of support elements on the support surface of the table in a predetermined position with a placement device.

2. The method of claim 1, further comprising capturing an image of the at least one support element disposed on the support surface of the table, and verifying whether the at least one support element is placed on the predetermined position on the support surface of the table based on the captured image.

3. The method of claim 1, further comprising returning unused support elements of the plurality of support elements to the container.

4. The method of claim 1, further comprising: downloading data from an external source, the data providing information related to the positioning of support elements on the support surface of the table; and placing the support elements on the support surface of the table in predetermined positions with a placement device based on the downloaded data.

5. The method of claim 4, wherein the data is one of CAD data and Gerber data.

6. The method of claim 4, wherein the data is taken from a third party source.

7. The method of claim 1, further comprising determining whether the substrate is properly supported, and, if not properly supported, identifying an area of the substrate requiring additional or less support.

8. The method of claim 7, further comprising identifying at least one location on a support table to move a support element or remove a support element, and placing a support element on the at least one location if additional support is required.

9. The method of claim 8, further comprising verifying the placement accuracy of the support element.

10. The method of claim 9, wherein identifying the area of the substrate and verifying the placement accuracy are performed with an imaging system.

11. The method of claim 1, further comprising identifying the positions of support elements on the support surface of the table, and optimizing the placement positions of the support elements on the support surface of the table with a placement device.

12. The method of claim 11, further comprising placing the support elements on the positions of the support surface of the table with the placement device.

13. The method of claim 11, wherein the identifying the positions of the support elements comprises downloading data from an external source, the data providing information related to the positions of the support elements on the support surface of the table.

14. The method of claim 11, wherein the optimizing the placement of the support elements comprises placing support elements with the placement device from an outward position to an inward position.
